(19) Europäisches Patentamt
European Patent Office
Office européen des brevets

(11) **EP 3 267 774 B1**

(12) **EUROPEAN PATENT SPECIFICATION**

(45) Date of publication and mention
of the grant of the patent:
**13.04.2022 Bulletin 2022/15**

(21) Application number: **17180290.3**

(22) Date of filing: **07.07.2017**

(51) International Patent Classification (IPC):
**H05K 7/20** (2006.01) **H02M 1/32** (2007.01)
**H02M 7/5387** (2007.01)

(52) Cooperative Patent Classification (CPC):
**H05K 7/20945; H02M 1/32;** H02M 1/327;
H02M 7/5387

(54) **METHOD AND APPARATUS OF EVALUATING HEAT DISSIPATION SYSTEM CONDITION FOR POWER MODULE**

VERFAHREN UND VORRICHTUNG ZUR BEURTEILUNG DER WÄRMEABLEITUNGSSYSTEMBEDINGUNG FÜR EIN LEISTUNGSMODUL

PROCÉDÉ ET APPAREIL D'ÉVALUATION DE L'ÉTAT D'UN SYSTÈME DE DISSIPATION DE CHALEUR POUR MODULE DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.07.2016 CN 201610536450**

(43) Date of publication of application:
**10.01.2018 Bulletin 2018/02**

(73) Proprietor: **DELTA ELECTRONICS (SHANGHAI) CO., LTD**
**Shanghai 201209 (CN)**

(72) Inventors:
• **HUANG, Wei**
**SHANGHAI, 201209 (CN)**
• **SUN, Zongyu**
**SHANGHAI, 201209 (CN)**
• **LU, Yansong**
**SHANGHAI, 201209 (CN)**

(74) Representative: **Cabinet Beau de Loménie**
**158, rue de l'Université**
**75340 Paris Cedex 07 (FR)**

(56) References cited:
**US-A- 5 712 802**

## Description

TECHNICAL FIELD

The present disclosure generally relates to the field of electronic circuit technology, and more particularly, to a method and apparatus of evaluating a heat dissipation system condition for a power module.

BACKGROUND

In high-power power electronic products, a power module composed of switches (including, but not limited to, insulated gate bipolar transistors, metal-oxide semiconductor field effect transistors, etc.) is the core of the product. The performance and design specifications of the power module basically determine main performance indicators of the high-power power electronic products.

In a traditional high-power power electronic apparatus composed of inverters, devices such as transducers or converters occupy a large proportion, and the core part of such type of power electronic apparatus is the inverter composed of switches. The high-power inverter operates under high-voltage large-current, which has a high demand on the reliability and availability of the converter system. How to design power modules with convenient maintenance, high reliability, and ultrahigh availability is the most important issue in power electronic design.

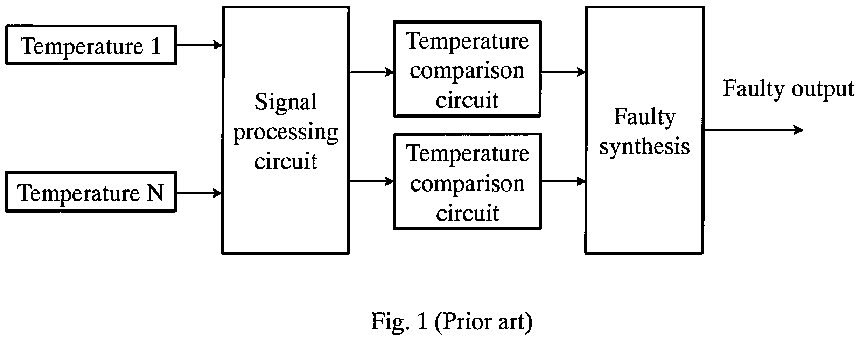

At present, in a mainstream power module design scheme, it is only determined whether a temperature of a certain point around the switch is overheated. The schematic diagram of the scheme is shown in Fig. 1. By detecting a temperature of a thermistor in a transistor or a temperature point of a radiator near the transistor, a sampled temperature value is compared with a fixed value. When the sampled temperature value is higher than a certain fixed value, the power module immediately stops operating and reports an over-temperature fault. However, there are many reasons for the over-temperature fault, including over-power output, high environment temperature, radiator dust depositing, poor radiator fins or cooling fluid flow path blockage, poor heat conducting silicone grease, malfunction protection caused when a sampling protection circuit is disturbed or damaged, or the like. It is difficult for an analyst to determine a specific reason of the fault from the over-temperature fault. The power module needs to be dismantled from the machine to be detected. The cause may be found out by a plurality of disassembly tests, which greatly reduces the maintenance efficiency of the module.

Therefore, a novel approach is needed to evaluate the heat dissipation system condition for the power module.

The above information disclosed in this Background section is for the purpose of reinforcing the understanding of the background of the present disclosure and therefore can include information that does not constitute prior art known to those of ordinary skill in the art.

US Patent Number: US5712802A discloses a method for providing thermal protection for forced air cooled power electronic semiconductors without direct measurement of semiconductor temperature, wherein the semiconductors is mounted on a heat sink over which cooling air is blown, includes the steps of computing the cooling air mass flow rate, creating an electronic model of the semiconductor/heat sink combination and estimating the semiconductor junction temperature from the mass flow rate and model.

SUMMARY

The present disclosure provides a method and an apparatus of evaluating a heat dissipation system condition for a power module according to claims 1 and 8, respectively, which may perform fault forewarning and initially determine a fault location.

Other features and advantages of the present disclosure will become apparent from the following detailed description, or in part, may be learned from practice of the present disclosure.

According to an aspect of the present disclosure, there is provided a method of evaluating a heat dissipation system condition for a power module, the power module including at least a switch, a DC busbar, a heat dissipation system, and a heat dissipation system condition evaluating apparatus, the method including:

acquiring at least one parameter of the power module through an acquiring module of the heat dissipation system condition evaluating apparatus;

calculating, by a processing module of the heat dissipation system condition evaluating apparatus, a thermal resistance between a node of the switch and the environment based on the at least one parameter;

calculating, by the processing module of the heat dissipation system condition evaluating apparatus, a cooling fluid flow rate based on the at least one parameter;

comparing, by a determining module of the heat dissipation system condition evaluating apparatus, the thermal resistance between a node of the switch and the environment with a first preset value, and determining the heat dissipation system condition according to a comparison result; and

determining, by the determining module of the heat dissipation system condition evaluating apparatus, a fault cause based on the thermal resistance between the node of the switch and the environment and a change of the cooling fluid flow rate, wherein the determining (S812) the fault cause based on the thermal resistance between the node of the switch and the environment and a change of the flow rate comprises: when the thermal resistance between the node of the switch and the environment becomes larger and the flow rate becomes smaller, sending out a forewarning signal, and further determining whether the forewarning signal is sent out by a plurality of power modules, if it is, determining that a common part of the heat dissipation system is abnormal, and if it is not, determining that a cooling component of the power module which sends a forewarning signal is abnormally blocked;when the thermal resistance between the node of the switch and the environment becomes larger and the flow rate remains unchanged, sending out a forewarning signal, and determining whether a structure or a heat conducting medium of a cooling component in the heat dissipation system is abnormal; and when the thermal resistance between the node of the switch and the environment remains unchanged and the flow rate becomes larger, sending out a forewarning signal, and determining whether a structure or a heat conducting medium of a cooling component in the heat dissipation system is abnormal.

In an exemplary embodiment of the present disclosure, the at least one parameter includes one or more of: an environment temperature where the power module is in, an internal temperature of the switch, a switching frequency of the switch, an output current of the power module, a voltage of the DC busbar, an inlet temperature of a cooling component of the heat dissipation system, and an outlet temperature of the cooling component of the heat dissipation system.

In an exemplary embodiment of the present disclosure, the calculating the thermal resistance between a node of the switch and the environment includes: calculating a loss power of the switch according to the at least one parameter, and calculating the thermal resistance between a node of the switch and the environment according to the following formula,

$$ R_{ja} = R_{jn} + \frac{T_{ntc} - T_a}{P_{loss}} \; ; $$

wherein $P_{loss}$ is the loss power of the switch, $T_{ntc}$ is an internal temperature of the switch, $T_a$ is an environment temperature, $R_{jn}$ is a thermal resistance between an internal node of the switch and a thermistor, and the thermal resistance $R_{jn}$ between the internal node of the switch and the thermistor is a given parameter.

In an exemplary embodiment of the present disclosure, the comparing the thermal resistance between a node of the switch and the environment with a first preset value and determining the heat dissipation system condition according to a comparison result includes: determining that the heat dissipation system is in a good condition when the thermal resistance between the node of the switch and the environment is less than the first preset value; and sending out a forewarning signal when the thermal resistance between the node of the switch and the environment is greater than the first preset value.

In an exemplary embodiment of the present disclosure, the first preset value is a thermal resistance between the node of the switch and the environment when the environment temperature and a junction temperature of the switch are in ideal states and the power module is under full load operation.

In an exemplary embodiment of the present disclosure, the method further includes: comparing the thermal resistance between a node of the switch and the environment with a second preset value, and sending out a fault shutdown signal when the thermal resistance exceeds the second preset value.

In an exemplary embodiment of the present disclosure, the calculating cooling fluid flow rate includes: calculating a loss power of the switch according to the at least one parameter and calculating the cooling fluid flow rate of the heat dissipation system according to the following formula,

$$ Q = \frac{P_{loss}}{\lambda * (T_{out} - T_{in}) * C} \; ; $$

wherein $P_{loss}$ is the loss power of the switch, $T_{in}$ is an inlet temperature of a cooling component, $T_{out}$ is an outlet temperature of the cooling component, C is a specific heat capacity of the cooling fluid, $\lambda$ is a conduction correction parameter, and the specific heat capacity C of the cooling fluid and the conduction correction parameter $\lambda$ are given parameters.

In an exemplary embodiment of the present disclosure, the method further includes adjusting the given parameters respectively through external communication.

In an exemplary embodiment of the present disclosure, the method further includes: calculating a loss power of the switch according to the at least one parameter, and calculating an internal junction temperature of the switch according to the following formula,

$$ T_j = P_{loss} * R_{ja} + T_a \; ; $$

wherein $P_{loss}$ is the loss power of the switch, $R_{ja}$ is a thermal resistance between a node of the switch and the environment, and $T_a$ is an environment temperature; and
when the internal junction temperature of the switch exceeds a third preset value, an over-temperature forewarning signal is sent out, and when the internal junction temperature of the switch exceeds a fourth preset value, an over-temperature fault signal is sent out.

According to an aspect of the present disclosure, there is provided an apparatus of evaluating a heat dissipation system condition for a power module, the apparatus of evaluating a heat dissipation system condition being located in the power module, wherein the power module includes at least a switch, a DC busbar and a heat dissipation system, and the apparatus includes:

an acquiring module, configured to acquire at least one parameter of the power module;
a processing module, configured to calculate a thermal resistance between a node of the switch and the environment based on the at least one parameter, and calculate cooling fluid flow rate based on the at least one parameter; and
a determining module, configured to compare the thermal resistance between a node of the switch and the environment with a first preset value, and determine the heat dissipation system condition according to a comparison result, and determine a fault cause based on the thermal resistance between the node of the switch and the environment and a change of the cooling fluid flow rate,
wherein the determining module (706) is further configured to:when the thermal resistance between the node of the switch and the environment becomes larger and the flow rate becomes smaller, send out a forewarning signal, and further determine whether the forewarning signal is sent out by a plurality of power modules, if it is, determine that a common part of the heat dissipation system is abnormal, and if it is not, determine that a cooling component of the power module which sends a forewarning signal is abnormally blocked;when the thermal resistance between the node of the switch and the environment becomes larger and the flow rate remains unchanged, send out a forewarning signal, and determine whether a structure or a heat conducting medium of a cooling component in the heat dissipation system is abnormal; and when the thermal resistance between the node of the switch and the environment remains unchanged and the flow rate becomes larger, send out a forewarning signal, and determine whether a structure or a heat conducting medium of a cooling component in the heat dissipation system is abnormal.

In an exemplary embodiment of the present disclosure, the heat dissipation system includes an air-cooled heat dissipation system and/or a water-cooled heat dissipation system, the air-cooled heat dissipation system includes a cooling component and a heat dissipation fan, and the water-cooled heat dissipation system includes a cooling component and a circulating pump.

In an exemplary embodiment of the present disclosure, the at least one parameter includes one or more of: an environment temperature where the power module is in, an internal temperature of the switch, a switching frequency of the switch, an output current of the power module, a voltage of the DC busbar, an inlet temperature of a cooling component of the heat dissipation system, and an outlet temperature of the cooling component of the heat dissipation system.

In an exemplary embodiment of the present disclosure, the processing module is further configured to: calculate a loss power of the switch according to the at least one parameter, and calculate the thermal resistance between a node of the switch and the environment according to the following formula,

$$R_{ja} = R_{jn} + \frac{T_{ntc} - T_a}{P_{loss}} ;$$

wherein $P_{loss}$ is the loss power of the switch, $T_{ntc}$ is an internal temperature of the switch, $T_a$ is an environment temperature, $R_{jn}$ is a thermal resistance between an internal node of the switch and a thermistor, and the thermal resistance $R_{jn}$ between the internal node of the switch and the thermistor is a given parameter.

In an exemplary embodiment of the present disclosure, the determining module is further configured to: determine that the heat dissipation system is in a good condition when the thermal resistance between the node of the switch and the environment is less than the first preset value; and send out a forewarning signal when the thermal resistance between the node of the switch and the environment is greater than the first preset value.

In an exemplary embodiment of the present disclosure, the determining module is further configured to: compare the thermal resistance between a node of the switch and the environment with a second preset value, and send out a fault shutdown signal when the thermal resistance exceeds the second preset value.

In an exemplary embodiment of the present disclosure, the processing module is further configured to: calculate a loss power of the switch according to the at least one parameter and calculate the cooling fluid flow rate of the heat dissipation system according to the following formula,

$$Q = \frac{P_{loss}}{\lambda * (T_{out} - T_{in}) * C} ;$$

wherein $P_{loss}$ is the loss power of the switch, $T_{in}$ is an inlet temperature of a cooling component, $T_{out}$ is an outlet temperature of the cooling component, $C$ is a specific heat capacity of the cooling fluid, $\lambda$ is a conduction correction parameter, and the specific heat capacity $C$ of the cooling fluid and the conduction correction parameter $\lambda$ are given parameters.

In an exemplary embodiment of the present disclosure, the apparatus further includes a communication module, configured to adjust the given parameters respectively.

In an exemplary embodiment of the present disclosure, the processing module is further configured to: calculate an internal junction temperature of the switch according to the following formula,

$$T_j = P_{loss} * R_{ja} + T_a;$$

wherein $P_{loss}$ is the loss power of the switch, $R_{ja}$ is a thermal resistance between a node of the switch and the environment, and $T_a$ is an environment temperature; and

the determining module is further configured to: when the internal junction temperature of the switch exceeds a third preset value, send out an over-temperature forewarning signal, and when the internal junction temperature of the switch exceeds a fourth preset value, send out an over-temperature fault signal.

Through the method and apparatus of evaluating a heat dissipation system condition for a power module according to the present disclosure, a heat dissipation system condition for a power module may be evaluated and an overall assessment score may be given. Meanwhile, a location and cause of the fault may be initially determined, including the radiator dust depositing and pipeline blockage forewarning, abnormal forewarning of a heat dissipation fan or a circulating pump of the heat dissipation system, and other abnormal forewarning of the radiator, such as falling off of radiator fins, damage of radiator pipes, serious shutdown caused by radiator dust depositing and pipeline blockage, over-temperature forewarning of switches, and over-temperature fault protection.

It is to be understood that the present invention is only defined by the appended claims.

BRIEF DESCRIPTION OF THE DRAWINGS

Above and other objectives, features and advantages of the present disclosure will become more apparent by describing its exemplary embodiments in detail with reference to the following accompanying drawings.

Fig. 1 shows a schematic diagram for determining fault of a power module in the prior art.
Fig. 2 shows a schematic diagram of a topology structure of a power module and a parameter sampling point according to an exemplary embodiment of the present disclosure.
Fig. 3 shows a schematic diagram of three topology structures of the power module.
Fig. 4 shows a schematic diagram of an air-cooled heat dissipation system according to an exemplary embodiment of the present disclosure.
Fig. 5 shows a schematic diagram of a water-cooled heat dissipation system according to an exemplary embodiment of the present disclosure.
Fig. 6 shows a schematic diagram of the design of the present disclosure.

Fig. 7 shows a block diagram of an apparatus of evaluating a heat dissipation system condition for a power module according to an exemplary embodiment of the present disclosure.
Fig. 8 shows a flow chart of a method of evaluating a heat dissipation system condition for a power module according to an exemplary embodiment of the present disclosure.
Fig. 9 shows a score curve of evaluating a heat dissipation system condition according to an exemplary embodiment of the present disclosure.
Fig. 10 is a graph showing the relationship between an internal junction temperature $T_j$ of a switch, the output power P of the power module, and the environment temperature $T_a$ according to an exemplary embodiment of the present disclosure.

DETAILED DESCRIPTION

The exemplary embodiments will now be described more fully with reference to accompanying drawings. However, the exemplary embodiments may be embodied in many forms and should not be construed as limited to the embodiments set forth herein. Rather, providing such embodiments makes the present disclosure thorough and complete, and will fully convey the concepts of the exemplary embodiments to those skilled in the art. The drawings are merely illustrative of the present disclosure and are not necessarily drawn to scale. The same reference numerals in the drawings denote the same or similar parts, and thus repeated description thereof will be omitted.

In addition, the features, structures, or characteristics described may be combined in one or more embodiments in any suitable manner. In the following description, many specific details are provided to give a full understanding of the embodiments of the present disclosure. However, those skilled in the art will appreciate that one or more of these specific details may be practiced without practicing the technical solutions of the present disclosure, or other methods, components, steps and the like may be employed. In other instances, well-known structures, methods, implementations or operations are not shown or described in detail to avoid obscuring aspects of the present disclosure.

Some blocks shown in the figures are functional entities and do not necessarily have to correspond to a physically or logically separate entity. That is, these functional entities may be implemented in a software form or may be implemented in one or more hardware modules or integrated circuits, or in various networks and/or processor devices and/or microcontroller devices, to implement these functional entities.

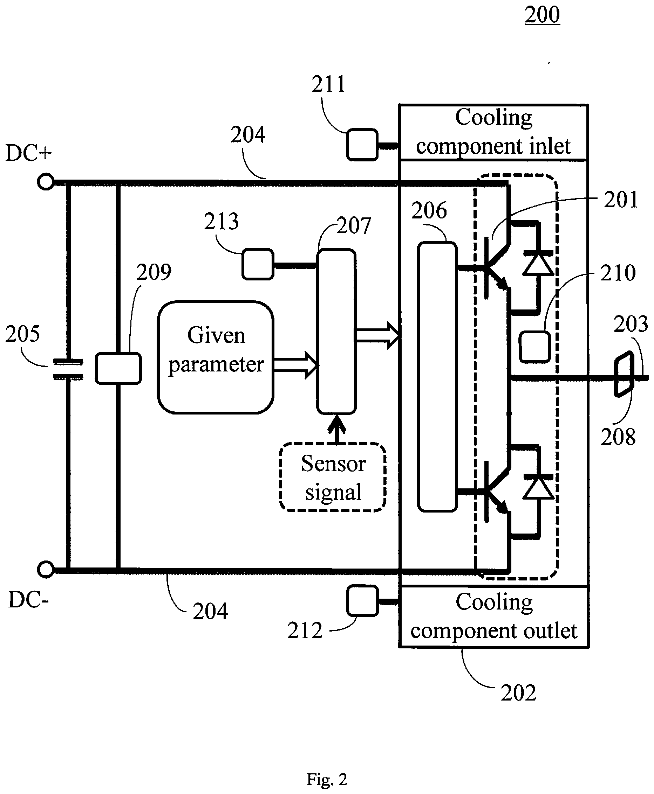

Fig. 2 shows a schematic diagram of a topology structure of a power module and a parameter sampling point according to an exemplary embodiment of the present disclosure. As shown in Fig. 2, the power module 200 includes a switch 201, a cooling component 202 (including a water-cooled cooling component and/or an air-cooled cooling component), an AC busbar 203, a DC busbar 204, a DC support capacitor 205, a drive control apparatus 206, various types of sensors, and a heat dissipation system condition evaluation apparatus 207. In the embodiment, the sensor includes a current sensor 208 for measuring an output current of the module, a voltage sensor 209 for measuring a voltage across the DC busbar, a temperature sensor 210 for measuring an internal temperature of the switch, a temperature sensor 211 for measuring a temperature at an inlet of the cooling component, a temperature sensor 212 for measuring an outlet temperature of the cooling component, and a temperature sensor 213 for measuring the environment temperature.

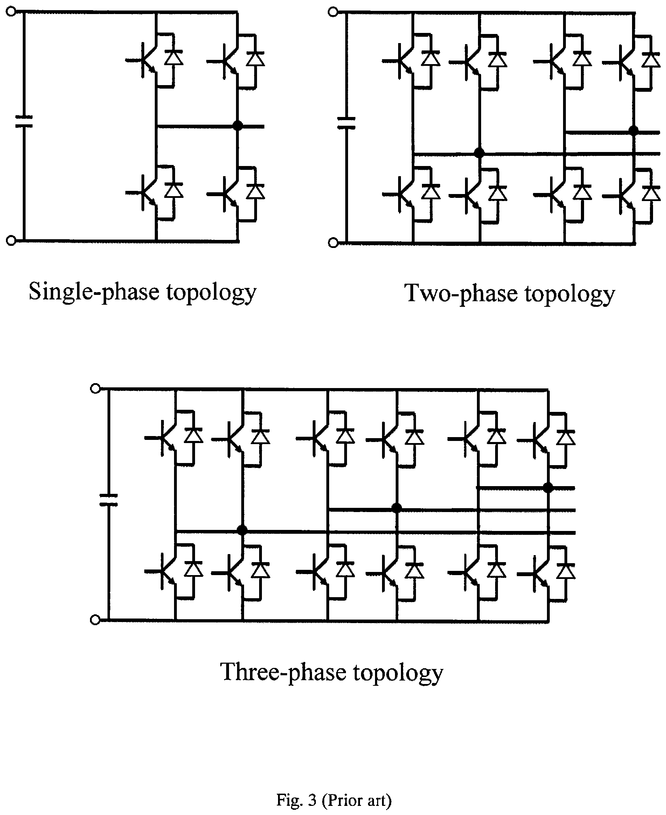

Fig. 3 shows a schematic diagram of three topology structures of the power module. As shown in Fig. 3, the power module may be classified into a single-phase module, a two-phase module and a three-phase module according to the number of phases. Both the two-phase module and the three-phase module are derived from the single-phase module, which are obtained by connecting two or three single-phase modules in parallel, and share a DC support capacitor and its related components.

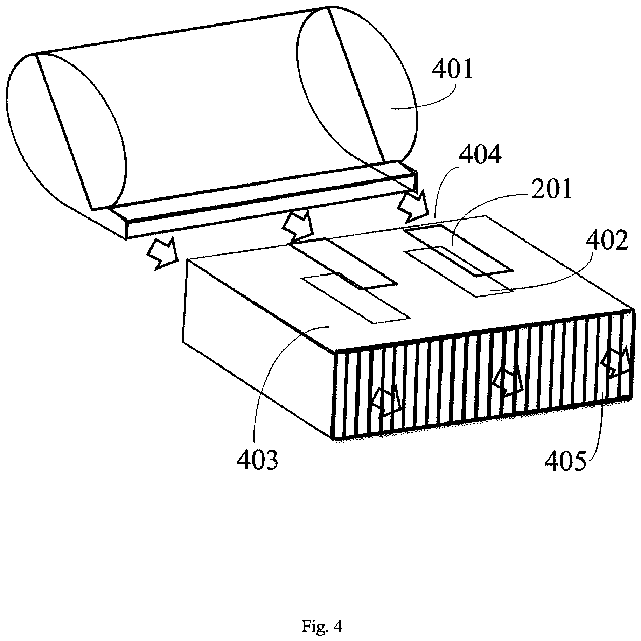

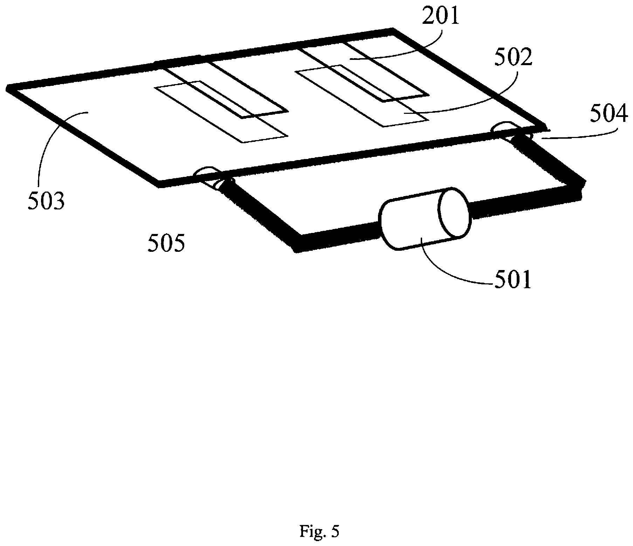

The power module 200, as a power output module of a converter (transducer) system, inevitably generates loss when the switch 201 outputs power. These losses are directly converted into heat. When the heat is not taken away in time, it may directly cause the increase of an internal temperature of the switch 201. If the switch 201 is operated at a high temperature for a long period of time, the operating life of the switch 201 will be greatly reduced. When the internal temperature of the switch 201 is higher than a limit value, it will directly lead to its fault. The heat generated by the switch 201 in the power module 200 is mainly taken away by the cooling component 202, such that the switch 201 is in a good operating environment, which improves the operational stability and life of the switch 201. Currently, the cooling component 202 is classified into an air-cooled cooling component and a water-cooled cooling component. As shown in Fig. 4, the heat dissipation fan 401 and the air-cooled cooling component in the system constitute an air-cooled heat dissipation system. The air-cooled cooling component includes a heat-conducting silicone grease 402 and an air-cooled radiator 403. The air-cooled radiator 403 has an air inlet 404 and an air outlet 405. The switch 201 is provided above the heat-conducting silicone grease 402 of the air-cooled radiator 403. As shown in Fig. 5, the circulating water pump 501 and the water-cooled cooling component in the system constitute a water-cooled heat dissipation system. The water-cooled cooling component includes a heat-conducting silicone grease 502 and a water-cooled plate 503. The water-cooled plate 503 has a water inlet 504 and a water outlet 505. The switch 201 is provided above the heat-conducting silicone grease 502 of the water-cooled plate 503.

When the air-cooled heat dissipation system is operated for a long period of time or operated under a poor environment (dust, sand or the like), the air-cooled radiator 403 will gather dust, which causes the reduce of the air flow, and the reduce of the heat dissipation capacity of the heat dissipation system. As for the water-cooled heat dissipation system, the heat dissipation pipeline will be blocked over time due to water quality, electrical corrosion and other reasons, thereby reducing the heat dissipation capacity of the water-cooled heat dissipation system. Both the dust depositing of the air-cooled radiator 403 and blockage of the heat dissipation pipeline will seriously affect the heat dissipation of the switch 201, such that the switch 201 will operate in a relatively high environment temperature for a long time, which greatly reduces the operating life of the switch 201. Even when the output power P of the power module 200 is relatively large, the temperature of the switch 201 is too high due to the decrease of the heat dissipation capacity of the heat dissipation system, resulting in over-temperature protection, and the power module 200 may only be shut down or unloaded, which greatly reduces the utilization of the power module 200.

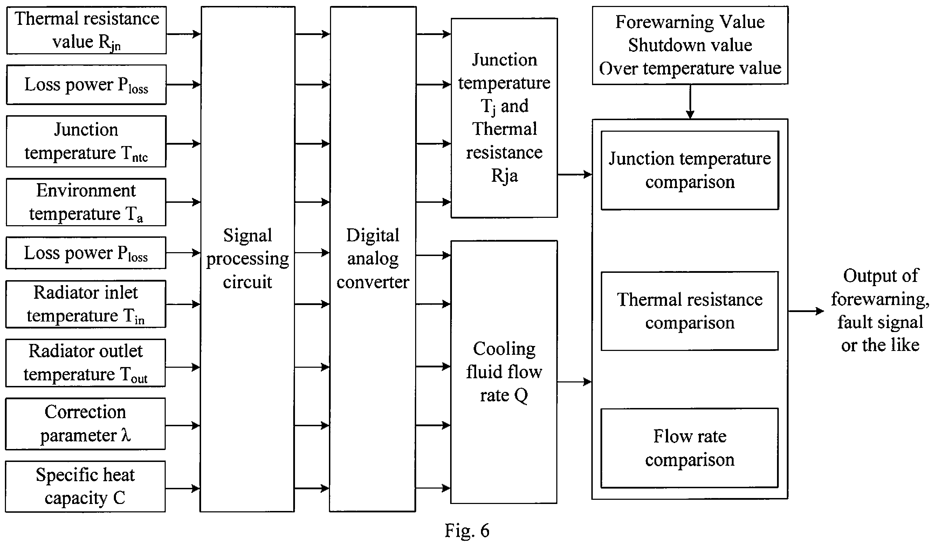

Combining with previous experience, based on the complexity of fault reasons of the power module heat dissipation system, and comprehensively considering the intelligent design requirement of the power module of the high power inverter, the present disclosure proposes a method and an apparatus of evaluating a heat dissipation system condition for a power module. The ideas for design are shown in Fig. 6. On the basis of acquiring the temperature of each part of the power module 200, by combining with real-time parameters of the power module 200, such as the voltage of the DC busbar and output current, etc., an integrated score of the heat dissipation system condition is obtained by calculating, analyzing, and comparing respective key parameters. When the integrated score is below a predetermined value, the heat dissipation system condition evaluating apparatus 207 sends sub-health forewarning information to the system. Under the forewarning state, the power module 200 is required to perform the load shedding operation. When the integrated score is below a limit value, the heat dissipation system condition evaluating apparatus 207 sends an abnormal signal to the system while the power module 200 is actively shut down. When a certain characteristic parameter of each index is beyond the limit criterion, for example, when the internal junction temperature $T_j$ of the switch exceeds a predetermined value, the power module 200 will automatically shut down and report the corresponding fault signal. After the system receives forewarning of the power module 200, a maintainer has sufficient time to prepare for the maintenance. When the power module 200 is shut down for protection, the problem of the heat dissipation system may be determined or eliminated through the information such as the previous forewarning, such that the maintenance efficiency is improved.

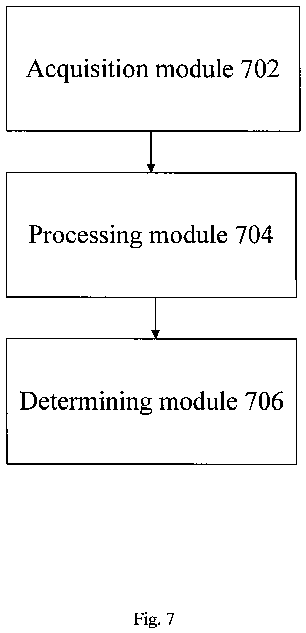

Fig. 7 shows a block diagram of an apparatus of evaluating a heat dissipation system condition for a power module according to an exemplary embodiment of the present disclosure. Combining with Figs. 6 and 7, a heat dissipation system condition evaluating apparatus 207 is located within the power module 200 and includes an acquisition module 702 for acquiring, through the sensor, the voltage of the DC busbar 204 of the power module 200, the output current of the power module 200, the environment temperature $T_a$ at which the power module 200 is located, the cooling component inlet temperature $T_{in}$ of the power module 200, the cooling component outlet temperature $T_{out}$ of the power module 200, a thermistor temperature $T_{ntc}$ at a certain point within the switch 201, and the like. After passing through a signal processing circuit, the acquired signal is transmitted to a processing module by a digital-analog sampling module. The processing module 704 may employ a Microcontroller Unit (MCU) or an Application Specific Integrated Circuit (ASIC). The switching frequency of the power module is provided by the system where the power module 200 is located and transmitted to the processing module. The processing module may store a plurality of parameters. Some of the parameters may be adjusted depending on different employed cooling components. The parameters that need to be adjusted may be adjusted through external communication. The adjustable parameters include a thermal resistance $R_{jn}$ between an internal node of the switch of the power module and a thermistor, a specific heat capacity value C of the cooling fluid, a conduction correction coefficient $\lambda$, a heat dissipation system integrated score forewarning value, a heat dissipation system integrated score protection shutdown value and an over-temperature protection shutdown value. The heat dissipation system condition evaluating apparatus 207 calculates the output power P of the power module in real time through the acquired voltage of the DC busbar and the output current; calculates the loss power $P_{loss}$ of the switch in real time through the voltage of the DC busbar, the output current and the switching frequency; calculates a junction temperature $T_j$ of the switch through the loss power $P_{loss}$ of the switch, an internal thermistor temperature $T_{ntc}$ of the switch and the thermal resistance $R_{jn}$; calculates a thermal resistance $R_{ja}$ between a node of the switch of the power module and the environment according to a thermal resistance $R_{jn}$ between an internal node of the switch and a thermistor, the switch loss power $P_{loss}$, an internal thermistor temperature $T_{ntc}$ of the switch, and an environment temperature $T_a$; calculates a cooling fluid flow rate Q according to a deviation $\Delta T$ between the outlet and inlet temperature of the cooling component of the switch, the switch loss power $P_{loss}$, the specific heat capacity C of the cooling fluid, and the conduction correction parameter $\lambda$. A determining module 706 compares the thermal resistance $R_{ja}$ between the node of the switch and the environment with a first preset value, and determines the condition of the heat dissipation system based on the comparison result; and determines the cause of the fault according to thermal resistance $R_{ja}$ between the node of the switch and the environment and the cooling fluid flow rate Q. In one embodiment, the determining module 706 is further configured to compare the thermal resistance $R_{ja}$ between the node of the switch and the environment with a second preset value. When the thermal resistance exceeds the second preset value, a fault shutdown signal is sent out.

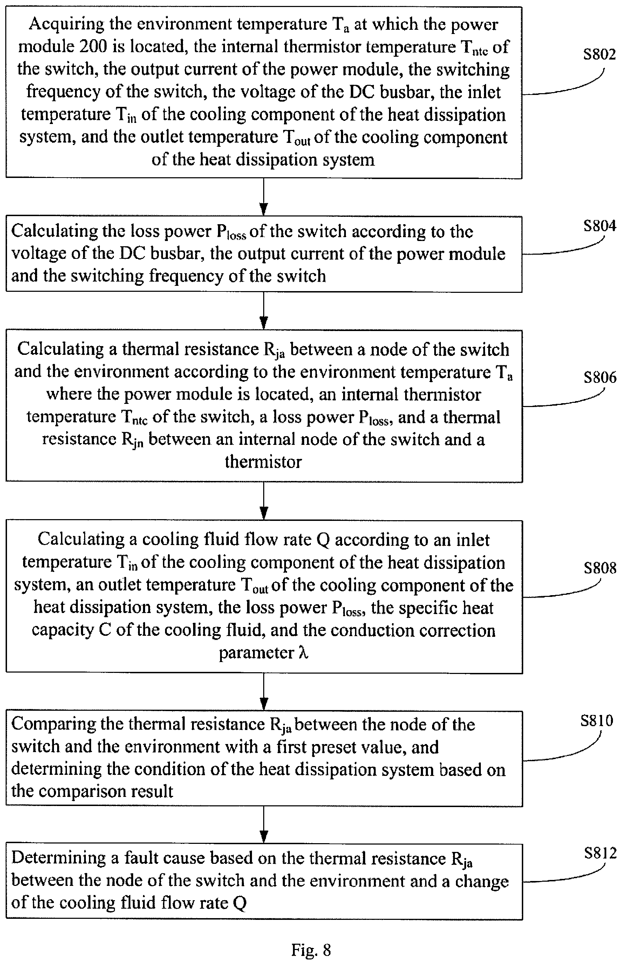

Fig. 8 shows a flow chart of a method of evaluating a heat dissipation system condition for a power module according to an exemplary embodiment of the present disclosure.

Fig. 8 shows a method of evaluating a heat dissipation system condition for a power module. The method is based on a structure of the above power module 200 and includes steps S802~S812.

In step S802, the environment temperature $T_a$ at which the power module 200 is located, the internal thermistor temperature $T_{ntc}$ of the switch, the output current of the power module, the switching frequency of the switch, the voltage of the DC busbar, the inlet temperature $T_{in}$ of the cooling component of the heat dissipation system, and the outlet temperature $T_{out}$ of the cooling component of the heat dissipation system are acquired.

The heat dissipation system condition evaluating apparatus 207 acquires, through a sensor, the environment temperature $T_a$ at which the power module 200 is located, the internal thermistor temperature $T_{ntc}$ of the switch, the output current of the power module, the voltage of the DC busbar, the inlet temperature $T_{in}$ of the cooling component of the heat dissipation system, and the outlet temperature $T_{out}$ of the cooling component of the heat dissipation system.

In step S804, the loss power $P_{loss}$ of the switch is calculated according to the voltage of the DC busbar, the output current of the power module and the switching frequency of the switch.

The loss power $P_{loss}$ of the switch is calculated according to the acquired voltage of the DC busbar, the output current of the power module 200 and the switching frequency of the switch 201 of the power module provided by the system where the power module 200 is located. There are many ways to calculate the loss power $P_{loss}$ in the prior art, and the present disclosure is not limited to a specific calculation method.

In step S806, a thermal resistance $R_{ja}$ between a node of the switch and the environment is calculated according to the environment temperature $T_a$ where the power module is located, an internal thermistor temperature $T_{ntc}$ of the switch, a loss power $P_{loss}$, and a thermal resistance $R_{jn}$ between an internal node of the switch and a thermistor.

A thermal resistance $R_{ja}$ between an internal node of the switch and the environment is calculated according to the acquired environment temperature $T_a$ where the power module is located, the internal thermistor temperature $T_{ntc}$ of the switch, the loss power $P_{loss}$, and the thermal resistance $R_{jn}$ between the internal node of the switch and a thermistor. There are a number of specific ways for the calculation, for example, the thermal resistance $R_{ja}$ between a node of the switch and the environment may be calculated by the following formula,

$$R_{ja} = R_{jn} + \frac{T_{ntc} - T_a}{P_{loss}} .$$

In step S808, a cooling fluid flow rate Q is calculated according to an inlet temperature $T_{in}$ of the cooling component of the heat dissipation system, an outlet temperature $T_{out}$ of the cooling component of the heat dissipation system, the loss power $P_{loss}$, the specific heat capacity C of the cooling fluid, and the conduction correction parameter $\lambda$.

The cooling fluid flow rate Q may be calculated according to the inlet temperature $T_{in}$ of the cooling component of the heat dissipation system, the outlet temperature $T_{out}$ of the cooling component of the heat dissipation system, the loss power $P_{loss}$, the specific heat capacity C of the cooling fluid, and the conduction correction parameter $\lambda$. There are a number of specific ways for the calculation, for example, the cooling fluid flow rate Q may be calculated by the following formula,

$$Q = \frac{P_{loss}}{\lambda * (T_{out} - T_{in}) * C} .$$

In step S810, the thermal resistance $R_{ja}$ between the node of the switch and the environment is compared with a first preset value, and the condition of the heat dissipation system is determined based on the comparison result.

The thermal resistance $R_{ja}$ between the node of the switch and the environment is compared with a first preset value, and it is determined that the heat dissipation system is in a good condition when the thermal resistance between the node of the switch and the environment is less than the first preset value; and it is determined that the heat dissipation system is abnormal and a forewarning signal is sent out when the thermal resistance between the node of the switch and the environment is greater than the first preset value. The first preset value may be a thermal resistance between the node of the switch and the environment when the environment temperature $T_a$ and the switch junction temperature $T_j$ are in ideal states and the power module 200 is under full load operation.

The thermal resistance $R_{ja}$ between a node of the switch and the environment may be further compared with a second preset value, and a fault shutdown signal is sent out when the thermal resistance $R_{ja}$ exceeds the second preset value. The first preset value and the second preset value may be set and modified according to the condition of the system and the specific needs of the user.

In step S812, a fault cause may be determined based on the thermal resistance $R_{ja}$ between the node of the switch and the environment and a change of the cooling fluid flow rate Q.

After the thermal resistance $R_{ja}$ between the node of the switch and the environment and the cooling fluid flow rate Q are calculated, the location or cause of the fault may be initially determined according to the change situation of the two parameters.

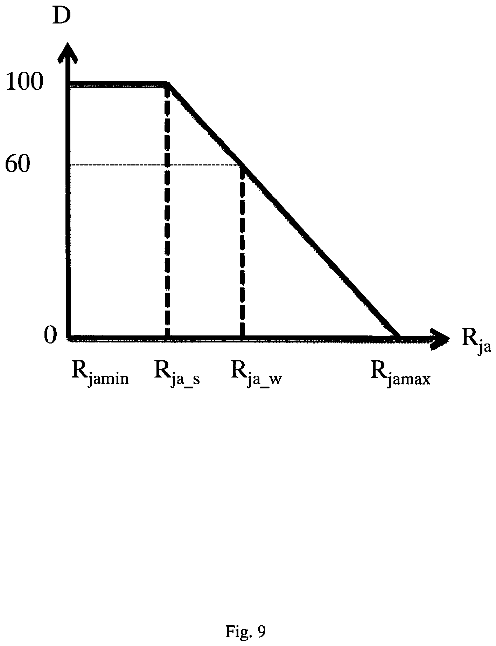

In the above method, the evaluation index of the heat dissipation system condition is based on the thermal resistance $R_{ja}$ between the node of the switch of the power module and the environment. Fig. 9 shows a score curve of evaluating a heat dissipation system condition. Theoretically, the power module has a designed standard thermal resistance $R_{ja\_s}$. When an actual thermal resistance $R_{ja}$ is less than the standard thermal resistance $R_{ja\_s}$, it may be because that a part of the radiator in the heat dissipation system is normal and a rotate speed of the heat dissipation fan becomes larger or a water flow rate of the circulating water pump become larger, the actual heat resistance $R_{ja}$ will be smaller than the standard thermal resistance $R_{ja\_s}$ in this case, but no matter how much the actual heat resistance $R_{ja}$ is smaller than the standard thermal resistance $R_{ja\_s}$, the heat dissipation system is considered in an ideal state. At this time, the heat dissipation system condition score D is determined as 100. When the actual thermal resistance $R_{ja}$ is greater than the standard thermal resistance $R_{ja\_s}$, it is considered that the performance of the heat dissipation system decreases. As a value of the actual thermal resistance $R_{ja}$ become larger and larger, the condition score D becomes lower and lower. When the actual thermal resistance $R_{ja}$ reaches the maximum value $R_{jamax}$, the condition score D is zero.

Under the ideal state, that is, when the entire heat dissipation system is under the standard state, the relationship between the internal junction temperature $T_j$ of the switch and the thermal resistance $R_{ja}$ is

$$R_{ja} = \frac{T_j - T_a}{\xi}$$

, wherein $\xi$ is the power loss when the power module 200 is under a full load operation state. In an embodiment, under a full load operation condition, when the environment temperature is 50°C, an ideal temperature of the internal junction temperature $T_j$ of the switch is 125°C and the corresponding thermal resistance $R_{ja}$ is the standard thermal resistance $R_{ja\_s}$. When the internal junction temperature $T_j$ of the switch reaches 135°C, the corresponding thermal resistance $R_{ja}$ is the standard thermal resistance $R_{ja\_w}$ and the condition score D of the power module 200 is 60. When the internal junction temperature $T_j$ of the switch reaches 150°C, the condition score D of the power module is 0. The condition score D of the power module 200 is only related to the thermal resistance $R_{ja}$ and is not related to the external environment temperature. The heat dissipation system condition evaluating calculation is conducted on the basis of the thermal resistance $R_{ja}$. When the thermal resistance $R_{ja}$ is less than or equal to the standard thermal resistance $R_{ja\_s}$, the entire heat dissipation system is in an ideal operating state. When the thermal resistance $R_{ja}$ is larger than the standard thermal resistance $R_{ja\_s}$, it is determined that the entire heat dissipation system has a different degree of abnormality. At this time, the power module 200 will issue sub-health forewarning to the system. The lower the condition score D is, the more serious the abnormality is. When the thermal resistance $R_{ja}$ increases to the value of $R_{ja\_w}$, the heat dissipation system condition score D is 60, that is, when the internal junction temperature $T_j$ of the switch is greater than 135°C, it is determined that the abnormality of the heat dissipation system is serious, and autonomous shutdown will be implemented. In one embodiment, the standard thermal resistance $R_{ja\_s}$ may be set to be a first predetermined value, and forewarning is conducted when the first predetermined value is reached. The value of $R_{ja\_w}$ is set to be a second predetermined value, and shutdown protection is conducted when the second predetermined value is reached. The above values may be set to be other values as needed. The condition evaluation of the heat dissipation system of the power module 200 is based on an integrated score of the radiator, the heat conducting silicone grease, flow rate of the cooling fluid, and quality of the cooling fluid and other factors in the heat dissipation system. These factors ultimately affect the thermal resistance $R_{ja}$, so the power module condition evaluation is scored based on the calculated thermal resistance $R_{ja}$. There are two major factors that affect the thermal resistance $R_{ja}$ between the node of the switch and the environment. The first factor is a factor of the flow path. A flow path of the air-cooled heat dissipation system is a channel for the cooling air to flow, and a flow path of the water-cooled heat dissipation system is a channel for the cooling liquid to circulate. When the power module 200 is operated for a long period of time, the flow path of the air-cooled heat dissipation system may be narrowed due to dust depositing or foreign matter intrusion, or the flow rate of air blown from the air-cooled radiator 403 may become smaller due to dust depositing or the aging problems of the air-cooled radiator 403, both of which will directly cause the flow of air flowing through the air-cooled radiator 403 to be reduced, thereby causing the heat resistance $R_{ja}$ between the node of the switch and the environment to become larger. A water-cooled radiator, such as a water-cooled plate 503, has an electrochemical corrosion phenomenon, and the effect of electrochemistry is accumulated after a long period of operation, resulting in a smaller flow path inside the water-cooled plate 503. The fine particles subject to the electrochemical corrosion are mixed in the cooling liquid, the quality of the cooling liquid used by the user does not reach the standard, or the flow rate flowing through the water cooling plate 503 is reduced due to abnormality of the circulating water pump of the water cooling system, all of which will cause the heat resistance $R_{ja}$ between the node of the switch and the environment to become larger. The second factor is abnormality of the radiator or heat conducting silicone grease, radiator fins of the air-cooled 403 may loose or fall off due to manufacturing process problems, and the water-cooled radiator may have poor welding problems, both of which will cause decline of the heat dissipation capacity of the radiator, thus affecting the thermal resistance $R_{ja}$. Both the air-cooled heat dissipation system and the water-cooled heat dissipation system will use the heat conducting silicone grease. If coating of the heat conducting silicone grease is too thick or too thin, the conduction effect will not be good, thus affecting the thermal resistance $R_{ja}$. At the same time, the heat conducting silicone grease will become dry over time, and it will slowly flow to the ground plane because of the role of gravity. The flow will cause uneven distribution of the heat conducting silicone grease at bottom of the switch 201. All of the above situations will cause the thermal resistance $R_{ja}$ to become larger.

Determination of the abnormal fault of the heat dissipation system is based on the thermal resistance $R_{ja}$ and the calculated cooling fluid flow rate Q.

According to the law of conservation of energy, once the heat dissipation system reaches the heat balance, the temperature of each point inside the power module 200 reaches an equilibrium point, and the temperature of each point remains unchanged. At this time, the loss power $P_{loss}$ of the switch 201 should be equal to the dissipated power of the heat dissipation system. The dissipated power of the heat dissipation system is the heat taken away by the cooling fluid per unit time. The flow rate Q of the cooling fluid at this time may be calculated after the temperature rise of the cooling fluid at the radiator inlet and the outlet is known. In one embodiment, the flow rate Q may be calculated by the following formula:

$$Q = \frac{P_{loss}}{\lambda * (T_{out} - T_{in}) * C}.$$

If it is detected that the thermal resistance $R_{ja}$ become larger and the cooling fluid flow rate Q becomes smaller at the same time, there may be two reasons. The first reason is the dust depositing or blockage inside the radiator, which will cause a poor heat dissipation effect of the radiator, and thus a larger thermal resistance $R_{ja}$. Meanwhile, due to reasons of dust depositing or blockage, the flow resistance inside the radiator will become larger, which will lead to a smaller cooling fluid flow rate Q. The second reason is a smaller wind speed of the heat dissipation fan of the heat dissipation system or a smaller rate of circulating pump, which causes a smaller cooling fluid flow rate Q and thus a larger thermal resistance $R_{ja}$. In any of the two cases, the power module 200 will send out an abnormal forewarning of the heat dissipation system to the system. The system may determine whether it is a radiator dust depositing problem, a radiator blockage problem, or a problem with the heat dissipation fan or a problem with circulating pump, according to the abnormal forewarning of the heat dissipation system being reported by a plurality of modules or a single module. If the system receives the abnormal forewarning of the heat dissipation system reported by a plurality of modules, it indicates that a common problem occurs for the plurality of power modules in the system. In this case, a common part of the power module for heat dissipation may have a problem, and it may be determined that the heat dissipation fan or the circulating pump is abnormal. If the system receives the abnormal forewarning of the heat dissipation system reported by a single power module, it indicates that an individual problem of the power module occurs. It may be determined that the radiator of the power module is dust deposited or abnormally blocked.

If it is detected that the thermal resistance $R_{ja}$ becomes larger and meanwhile the cooling fluid flow rate Q is substantially constant, it indicates that the fluid flow rate in the heat dissipation system is normal, and the radiator itself may be abnormal. This abnormality may also be divided into two kinds: heat-conducting silicone grease abnormality or radiator abnormality. The radiator abnormality is abnormality of the radiator structure, which may be loose radiator fins or water-cooled radiator flow path abnormality. There is no way to distinguish the two kinds of abnormality in detail, and the two kinds of abnormality are organized into one class.

If it is detected that the thermal resistance $R_{ja}$ remains unchanged and meanwhile the cooling fluid flow rate Q significantly increases, it is also determined that the heat-conducting silicone grease is abnormal or the radiator is abnormal. The standard value of $R_{ja}$ is calculated based on knowing the value of the cooling fluid flow rate Q. If the cooling fluid flow rate Q becomes larger, the thermal resistance $R_{ja}$ becomes smaller theoretically, and the thermal resistance $R_{ja}$ and the standard value basically remain unchanged at this time. In fact, the thermal resistance $R_{ja}$ has been already larger than the actual calculated theoretical value. Therefore, the determination is consistent with the case where the thermal resistance $R_{ja}$ becomes larger and meanwhile the cooling fluid flow rate Q is substantially constant.

Through the method of evaluating a heat dissipation system condition for a power module according to the present disclosure, a heat dissipation system condition for a power module may be evaluated and an overall assessment score may be given. Meanwhile, a location and cause of the fault may be initially determined, including the radiator dust depositing and pipeline blockage forewarning, abnormal forewarning of a heat dissipation fan or a circulating pump of the heat dissipation system, and other abnormal forewarning of the radiator, such as falling off of radiator fins, damage of radiator pipes, serious shutdown caused by radiator dust depositing and pipeline blockage.

The power module 200 having a heat dissipation system condition evaluating apparatus 207 not only transmits the heat dissipation system condition score D to the system, but also has functions of over-temperature forewarning and over-temperature protection, and transmits the information to the system through the specified communication protocol.

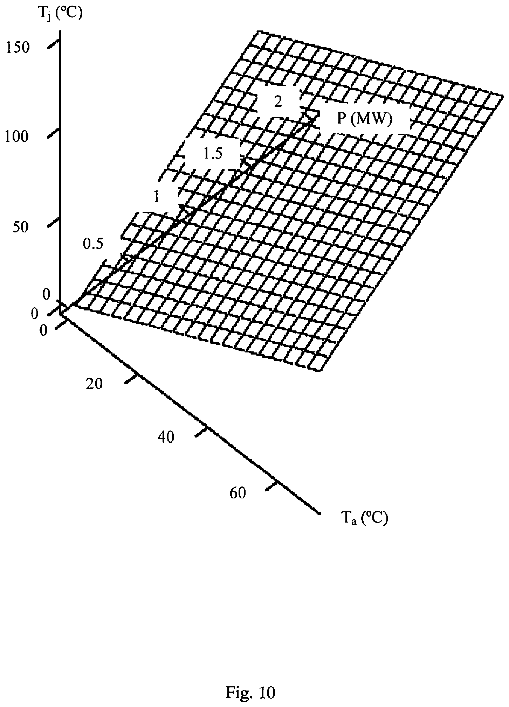

The internal junction temperature $T_j$ of the switch serves reference basis of the over-temperature forewarning and over-temperature protection of the present disclosure. In an embodiment, the internal junction temperature $T_j$ of the switch is calculated by $T_j = P_{loss} * R_{ja} + T_a$. The internal junction temperature $T_j$ of the switch is not only related to the thermal resistance $R_{ja}$, but also related to the power loss $P_{loss}$ of the power module 200 and the environment temperature $T_a$ where the power module 200 located. The switching loss $P_{loss}$ of the power module 200 is approximately proportional to the output power P. In the case where $R_{ja}$ is ideal, when the output power P of the power module 200 exceeds the rated power, the loss of the switch 201 becomes larger, which causes that the internal junction temperature $T_j$ of the switch will exceed 125°C under a relatively high environment temperature $T_a$, and then an over-temperature forewarning will be sent out. In the case where the environment temperature $T_a$ is relatively low, an appropriate overpower of the power module 200 does not cause an over-temperature forewarning. In the case where $R_{ja}$ is ideal, the relationship between the internal junction temperature $T_j$ of the switch, the output power P of the power module and the environment temperature $T_a$ are as shown in Fig. 10. In the actual operation of the power module 200, there may be a case where the thermal resistance $R_{ja}$ is large, but the internal junction temperature $T_j$ of the switch is not high, even lower than the ideal junction temperature, due to a low environment temperature or a low circulating liquid temperature. The power module 200 is still able to operate normally under this situation, but since the thermal resistance $R_{ja}$ is relatively large which indicates that the heat dissipation system already has a problem, the power module is required to send a forewarning to the system. In one embodiment, when it is detected that the junction temperature $T_j$ of the switch exceeds an over-temperature forewarning value, an over-temperature forewarning should be sent out, to remind the system or maintainer to maintain the power module 200. At this time, the power module 200 is still able to operate normally, and it will not be automatically shut down for protection. When the internal junction temperature $T_j$ of the switch exceeds the over-temperature protection value, the power module 200 sends out an over-temperature fault signal to the system and automatically shuts down on its own.

With the method of the present disclosure, the maintainer has sufficient maintenance preparation time, and the downtime is greatly reduced, which increases the operation efficiency. After receiving the forewarning signal, the maintainer may determine which specific part of the power module heat dissipation system is abnormal and thus adopts different maintenance measures, by reading the heat dissipation system operating parameters in the storage device at the time of sending out a forewarning signal.

With respect to the apparatus of the above embodiment, the specific mode in which each module performs the operation has been described in detail in the embodiment relating to the method, and the description thereof will not be described in detail herein. Exemplary embodiments of the present disclosure have been particularly shown and described above. It is to be understood that, the present disclosure is not limited to the detailed construction, arrangement, or implementation method described herein; rather, the present disclosure is intended to cover various modifications and equivalent arrangements included within the scope of the appended claims.

**Claims**

1. A method of evaluating a heat dissipation system condition for a power module, the power module comprising at least a switch, a DC busbar, a heat dissipation system, and a heat dissipation system condition evaluating apparatus, the method comprising:

   acquiring (S802) at least one parameter of the power module through an acquiring module (702) of the heat dissipation system condition evaluating apparatus;
   calculating (S806), by a processing module (704) of the heat dissipation system condition evaluating apparatus, a thermal resistance between a node of the switch and an environment based on parameters comprising an environment temperature where the power module is located, an internal thermistor temperature of the switch, a loss power of the switch, and a thermal resistance between an internal node of the switch and a thermistor;
   calculating (S808), by the processing module (704) of the heat dissipation system condition evaluating apparatus, a cooling fluid flow rate based on the at least one of the parameters;
   **characterized in** further comprising:

   comparing (S810), by a determining module (706) of the heat dissipation system condition evaluating apparatus, the thermal resistance between a node of the switch and the environment with a first preset value, and determining the heat dissipation system condition according to a comparison result; and
determining (S812), by the determining module (706) of the heat dissipation system condition evaluating apparatus, a fault cause based on the thermal resistance between the node of the switch and the environment and a change of the cooling fluid flow rate,
wherein the determining (S812) the fault cause based on the thermal resistance between the node of the switch and the environment and a change of the flow rate comprises:

   when the thermal resistance between the node of the switch and the environment becomes larger and the flow rate becomes smaller, sending out a forewarning signal, and further determining whether the forewarning signal is sent out by a plurality of power modules, if it is, determining that a common part of the heat dissipation system is abnormal, and if it is not, determining that a cooling component of the power module which sends a forewarning signal is abnormally blocked;
   when the thermal resistance between the node of the switch and the environment becomes larger and the flow rate remains unchanged, sending out a forewarning signal, and determining whether a structure or a heat conducting medium of a cooling component in the heat dissipation system is abnormal; and
   when the thermal resistance between the node of the switch and the environment remains unchanged and the flow rate becomes larger, sending out a forewarning signal, and determining whether a structure or a heat conducting medium of a cooling component in the heat dissipation system is abnormal.

2. The method of claim 1, wherein the at least one parameter comprises one or more of: the environment temperature where the power module is in, an internal temperature of the switch, a switching frequency of the switch, an output current of the power module, a voltage of the DC busbar, an inlet temperature of a cooling component of the heat dissipation system, and an outlet temperature of the cooling component of the heat dissipation system.

3. The method of claim 1, wherein the calculating (S806) the thermal resistance between the node of the switch and the environment comprises: calculating (S804) the loss power of the switch according to the at least one parameter, and calculating the thermal resistance between a node of the switch and the environment according to the following formula,

$$R_{\mathrm{ja}} = R_{jn} + \frac{T_{ntc} - T_a}{P_{\mathrm{loss}}};$$

wherein $P_{\mathrm{loss}}$ is the loss power of the switch, $T_{ntc}$ is the internal temperature of the switch, $T_a$ is the environment temperature, $R_{jn}$ is the thermal resistance between the internal node of the switch and the thermistor, and the thermal resistance $R_{jn}$ between the internal node of the switch and the thermistor is a given parameter which is adjusted through external communication.

4. The method of claim 1, wherein the comparing (S810) the thermal resistance between the node of the switch and the environment with a first preset value and determining the heat dissipation system condition according to a comparison result comprises: determining that the heat dissipation system is in a good condition when the thermal resistance between the node of the switch and the environment is less than the first preset value; and sending out a forewarning signal when the thermal resistance between the node of the switch and the environment is greater than the first preset value.

5. The method of claim 1, further comprising: comparing the thermal resistance between the node of the switch and the environment with a second preset value, and sending out a fault shutdown signal when the thermal resistance exceeds the second preset value.

6. The method of claim 1, wherein the calculating cooling fluid flow rate comprises:

calculating (S804) the loss power of the switch according to the at least one parameter and calculating the cooling fluid flow rate of the heat dissipation system according to the following formula,

$$Q = \frac{P_{\mathrm{loss}}}{\lambda * \left( T_{\mathrm{out}} - T_{\mathrm{in}} \right) * C};$$

wherein $P_{\mathrm{loss}}$ is the loss power of the switch, $T_{\mathrm{in}}$ is an inlet temperature of a cooling component, $T_{\mathrm{out}}$ is an outlet temperature of the cooling component, C is a specific heat capacity of the cooling fluid, $\lambda$ is a conduction correction parameter, and the specific heat capacity C of the cooling fluid and the conduction correction parameter $\lambda$ are given parameters which are adjusted through external communication.

7. The method of claim 1, further comprising: calculating (S804) the loss power of the switch according to the at least one parameter, and calculating an internal junction temperature of the switch according to the following formula,

$$T_j = P_{\mathrm{loss}} * R_{\mathrm{ja}} + T_a;$$

wherein $P_{\mathrm{loss}}$ is the loss power of the switch, $R_{\mathrm{ja}}$ is a thermal resistance between a node of the switch and the environment, and $T_a$ is the environment temperature; and
when the internal junction temperature of the switch exceeds a third preset value, an overtemperature forewarning signal is sent out, and when the internal junction temperature of the switch exceeds a fourth preset value, an overtemperature fault signal is sent out.

8. An apparatus of evaluating a heat dissipation system condition for a power module, the apparatus of evaluating a heat dissipation system condition being located in the power module, wherein the power module comprises at least a switch, a DC busbar and a heat dissipation system, and the apparatus comprises:

an acquiring module (702), configured to acquire at least one parameter of the power module;
a processing module (704), configured to calculate a thermal resistance between a node of the switch and the environment based parameters comprising an environment temperature where the power module is located, an internal thermistor temperature of the switch, a loss power of the switch, and a thermal resistance between an internal node of the switch and a thermistor, and calculate cooling fluid flow rate based on the at least one of the parameters; and
**characterized in that** the apparatus further comprises:

a determining module (706), configured to compare the thermal resistance between a node of the switch and the environment with a first preset value, and determine the heat dissipation system condition according to a comparison result, and determine a fault cause based on the thermal resistance between the node of the switch and the environment and a change of the cooling fluid flow rate,

wherein the determining module (706) is further configured to:

when the thermal resistance between the node of the switch and the environment becomes larger and the flow rate becomes smaller, send out a forewarning signal, and further determine whether the forewarning signal is sent out by a plurality of power modules, if it is, determine that a common part of the heat dissipation system is abnormal, and if it is not, determine that a cooling component of the power module which sends a forewarning signal is abnormally blocked;

when the thermal resistance between the node of the switch and the environment becomes larger and the flow rate remains unchanged, send out a forewarning signal, and determine whether a structure or a heat conducting medium of a cooling component in the heat dissipation system is abnormal; and

when the thermal resistance between the node of the switch and the environment remains unchanged and the flow rate becomes larger, send out a forewarning signal, and determine whether a structure or a heat conducting medium of a cooling component in the heat dissipation system is abnormal.

9. The apparatus of claim 8, wherein the at least one parameter comprises one or more of: the environment temperature where the power module is in, an internal temperature of the switch, a switching frequency of the switch, an output current of the power module, a voltage of the DC busbar, an inlet temperature of a cooling component of the heat dissipation system, and an outlet temperature of the cooling component of the heat dissipation system.

10. The apparatus of claim 8, wherein the determining module (706) is further configured to:
determine that the heat dissipation system is in a good condition when the thermal resistance between the node of the switch and the environment is less than the first preset value; and send out a forewarning signal when the thermal resistance between the node of the switch and the environment is greater than the first preset value.

11. The apparatus of claim 8, wherein the determining module (706) is further configured to:
compare the thermal resistance between a node of the switch and the environment with a second preset value, and send out a fault shutdown signal when the thermal resistance exceeds the second preset value.

12. The apparatus of claim 8, wherein the processing module (704) is further configured to:

calculate the loss power of the switch according to the at least one parameter and calculate the cooling fluid flow rate of the heat dissipation system according to the following formula,

$$Q = \frac{P_{\text{loss}}}{\lambda * \left( T_{\text{out}} - T_{\text{in}} \right) * C} ;$$

wherein $P_{\text{loss}}$ is the loss power of the switch, $T_{\text{in}}$ is an inlet temperature of a cooling component, $T_{\text{out}}$ is an outlet temperature of the cooling component, C is a specific heat capacity of the cooling fluid, $\lambda$ is a conduction correction parameter, and the specific heat capacity C of the cooling fluid and the conduction correction parameter $\lambda$ are given parameters which are adjusted through external communication.

13. The apparatus of claim 8, wherein the processing module (704) is further configured to:

calculate an internal junction temperature of the switch according to the following formula,

$$T_{\text{j}} = P_{\text{loss}} * R_{\text{ja}} + T_{\text{a}} ;$$

wherein $P_{\text{loss}}$ is the loss power of the switch, $R_{\text{ja}}$ is a thermal resistance between a node of the switch and the environment, and $T_{\text{a}}$ is the environment temperature; and
the determining module (706) is further configured to: when the internal junction temperature of the switch exceeds a third preset value, send out an over-temperature forewarning signal, and when the internal junction temperature of the switch exceeds a fourth preset value, send out an over-temperature fault signal.

**Patentansprüche**

1.  Verfahren zur Bewertung des Zustands eines Wärmeableitsystems für ein Energiemodul, wobei das Energiemodul mindestens einen Schalter, eine Gleichstromsammelschiene, ein Wärmeableitsystem und eine Vorrichtung zur Bewertung des Zustands des Wärmeableitsystems umfasst, wobei das Verfahren umfasst:

    Erfassen (S802) mindestens eines Parameters des Energiemoduls durch ein Erfassungsmodul (702) der Vorrichtung zur Bewertung des Zustands des Wärmeableitsystems,
    Berechnen (S806) eines Wärmewiderstands zwischen einem Knoten des Schalters und einer Umgebung auf der Grundlage von Parametern, die eine Umgebungstemperatur, in der sich das Energiemodul befindet, eine interne Thermistortemperatur des Schalters, eine Verlustleistung des Schalters und einen Wärmewiderstand zwischen einem internen Knoten des Schalters und einem Thermistor umfassen, durch ein Verarbeitungsmodul (704) der Vorrichtung zur Bewertung des Zustands des Wärmeableitsystems,
    Berechnen (S808) einer Kühlfluid-Durchflussrate durch das Verarbeitungsmodul (704) der Vorrichtung zur Bewertung des Zustands des Wärmeableitsystems auf der Grundlage des mindestens einen der Parameter,
    **dadurch gekennzeichnet, dass** es ferner umfasst:

    Vergleichen (S810) des Wärmewiderstands zwischen einem Knoten des Schalters und der Umgebung mit einem ersten voreingestellten Wert durch ein Bestimmungsmodul (706) der Vorrichtung zur Bewertung des Zustands des Wärmeableitsystems und Bestimmen des Zustands des Wärmeableitsystems entsprechend einem Vergleichsergebnis und
    Bestimmen (S812) einer Fehlerursache durch das Bestimmungsmodul (706) der Vorrichtung zur Bewertung des Zustands des Wärmeableitsystems auf der Grundlage des Wärmewiderstands zwischen dem Knoten des Schalters und der Umgebung und einer Änderung der Kühlfluid-Durchflussrate,
    wobei das Bestimmen (S812) der Fehlerursache auf der Grundlage des Wärmewiderstands zwischen dem Knoten des Schalters und der Umgebung und einer Änderung der Durchflussrate umfasst:

    wenn der Wärmewiderstand zwischen dem Knoten des Schalters und der Umgebung größer wird und die Strömungsrate kleiner wird, Aussenden eines Vorwarnsignals, und ferner Bestimmen, ob das Vorwarnsignal von mehreren Energiemodulen ausgesendet wird, wenn dies der Fall ist, Bestimmen, dass ein gemeinsamer Teil des Wärmeableitsystems anormal ist, und wenn dies nicht der Fall ist, Bestimmen, dass eine Kühlkomponente des Energiemoduls, das ein Vorwarnsignal aussendet, anormal blockiert ist,
    wenn der Wärmewiderstand zwischen dem Knoten des Schalters und der Umgebung größer wird und die Durchflussrate unverändert bleibt, Aussenden eines Vorwarnsignals und Bestimmen, ob eine Struktur oder ein wärmeleitendes Medium einer Kühlkomponente in dem Wärmeableitsystem anormal ist, und
    wenn der Wärmewiderstand zwischen dem Knoten des Schalters und der Umgebung unverändert bleibt und die Durchflussrate größer wird, Aussenden eines Vorwarnsignal und Bestimmen, ob eine Struktur oder ein wärmeleitendes Medium einer Kühlkomponente in dem Wärmeableitsystem anormal ist.

2.  Verfahren nach Anspruch 1, wobei der mindestens eine Parameter eines oder mehrere der Folgenden umfasst: die Umgebungstemperatur, in der sich das Energiemodul befindet, eine Innentemperatur des Schalters, eine Schaltfrequenz des Schalters, ein Ausgangsstrom des Energiemoduls, eine Spannung der Gleichstromsammelschiene, eine Einlasstemperatur einer Kühlkomponente des Wärmeableitsystems und eine Auslasstemperatur der Kühlkomponente des Wärmeableitsystems.

3.  Verfahren nach Anspruch 1, wobei das Berechnen (S806) des Wärmewiderstands zwischen dem Knoten des Schalters und der Umgebung umfasst: Berechnen (S804) der Verlustleistung des Schalters gemäß dem mindestens einen Parameter und Berechnen des Wärmewiderstands zwischen einem Knoten des Schalters und der Umgebung gemäß der folgenden Formel,

$$R_{ja} = R_{jn} + \frac{T_{ntc} - T_a}{P_{loss}}$$

wobei $P_{loss}$ die Verlustleistung des Schalters ist, $T_{ntc}$ die interne Temperatur des Schalters ist, $T_a$ die Umgebungstemperatur ist, $R_{jn}$ der Wärmewiderstand

zwischen dem internen Knoten des Schalters und dem Thermistor ist, und der Wärmewiderstand R_jn zwischen dem internen Knoten des Schalters und dem Thermistor ein gegebener Parameter ist, der mittels externer Kommunikation eingestellt wird.

4. Verfahren nach Anspruch 1, wobei das Vergleichen (S810) des Wärmwiderstands zwischen dem Knoten des Schalters und der Umgebung mit einem ersten voreingestellten Wert und das Bestimmen des Zustands des Wärmeableitsystems gemäß einem Vergleichsergebnis umfasst: Bestimmen, dass sich das Wärmeableitsystem in einem guten Zustand befindet, wenn der Wärmewiderstand zwischen dem Knoten des Schalters und der Umgebung kleiner als der erste voreingestellte Wert ist, und Aussenden eines Vorwarnsignals, wenn der Wärmewiderstand zwischen dem Knoten des Schalters und der Umgebung größer als der erste voreingestellte Wert ist.

5. Verfahren nach Anspruch 1, ferner umfassend: Vergleichen des Wärmewiderstands zwischen dem Knoten des Schalters und der Umgebung mit einem zweiten voreingestellten Wert und Aussenden eines Fehlerabschaltsignals, wenn der Wärmewiderstand den zweiten voreingestellten Wert überschreitet.

6. Verfahren nach Anspruch 1, wobei das Berechnen der Kühlfluid-Durchflussrate umfasst:

Berechnen (S804) der Verlustleistung des Schalters gemäß dem mindestens einen Parameter und Berechnen der Kühlfluid-Durchflussrate des Wärmeableitsystems gemäß der folgenden Formel,

$$Q = \frac{P_{loss}}{\lambda * (T_{out-} T_{in}) * C}$$

wobei $P_{loss}$ die Verlustleistung des Schalters ist, $T_{in}$ eine Einlasstemperatur einer Kühlkomponente ist, $T_{out}$ eine Auslasstemperatur der Kühlkomponente ist, C eine spezifische Wärmekapazität der Kühlflüssigkeit ist, $\lambda$ ein Leitungskorrekturparameter ist, und wobei die spezifische Wärmekapazität C der Kühlflüssigkeit und der Leitungskorrekturparameter $\lambda$ gegebene Parameter sind, die mittels externer Kommunikation eingestellt werden.

7. Verfahren nach Anspruch 1, ferner umfassend: Berechnen (S804) der Verlustleistung des Schalters gemäß dem mindestens einen Parameter und Berechnen einer internen Sperrschichttemperatur des Schalters gemäß der folgenden Formel,

$$T_j = P_{loss} * R_{ja} + T_a$$

wobei $P_{loss}$ die Verlustleistung des Schalters ist, $R_{ja}$ ein Wärmewiderstand zwischen einem Knoten des Schalters und der Umgebung ist und $T_a$ die Umgebungstemperatur ist, und wobei ein Übertemperatur-Vorwarnsignal ausgegeben wird, wenn die interne Sperrschichttemperatur des Schalters einen dritten voreingestellten Wert überschreitet, wird und ein Übertemperatur-Fehlersignal ausgegeben wird, wenn die interne Sperrschichttemperatur des Schalters einen vierten voreingestellten Wert überschreitet.

8. Vorrichtung zur Bewertung des Zustands eines Wärmeableitsystems für ein Energiemodul, wobei die Vorrichtung zur Bewertung des Zustands eines Wärmeableitsystems in dem Energiemodul angeordnet ist, wobei das Energiemodul mindestens einen Schalter, eine Gleichstromsammelschiene und ein Wärmeableitsystem umfasst, wobei die Vorrichtung umfasst:

ein Erfassungsmodul (702), das dazu konfiguriert ist, mindestens einen Parameter des Energiemoduls zu erfassen,
ein Verarbeitungsmodul (704), das dazu konfiguriert, einen Wärmewiderstand zwischen einem Knoten des Schalters und der Umgebung auf der Grundlage von Parametern zu berechnen, die eine Umgebungstemperatur, in der sich das Energiemodul befindet, eine interne Thermistortemperatur des Schalters, eine Verlustleistung des Schalters und einen Wärmewiderstand zwischen einem internen Knoten des Schalters und einem Thermistor umfassen, und die Kühlfluid-Durchflussrate auf der Grundlage des mindestens einen der Parameter zu berechnen,
**dadurch gekennzeichnet, dass** die Vorrichtung ferner umfasst:

ein Bestimmungsmodul (706), das dazu konfiguriert ist, den Wärmewiderstand zwischen einem Knoten des Schalters und der Umgebung mit einem ersten voreingestellten Wert zu vergleichen und den Zustand des Wärmeableitsystems gemäß einem Vergleichsergebnis zu bestimmen und eine Fehlerursache auf der Grundlage des Wärmewiderstands zwischen dem Knoten des Schalters und der Umgebung und einer Änderung der Kühlfluid-Durchflussrate zu bestimmen,
wobei das Bestimmungsmodul (706) ferner dazu konfiguriert ist,

wenn der Wärmewiderstand zwischen dem Knoten des Schalters und der Umgebung größer und die Durchflussrate kleiner wird, ein Vorwarnsignal auszusenden, und ferner zu bestimmen, ob das Vorwarnsignal von mehreren Energiemodulen ausgesendet wird, und, wenn dies der Fall ist, zu bestimmen, dass ein gemeinsamer Teil des Wärmeableitsystems anormal ist, und, wenn dies nicht der Fall ist, zu bestimmen, dass eine Kühlkomponente des Energiemoduls, das ein Vorwarnsignal aussendet, anormal blockiert ist,

wenn der Wärmewiderstand zwischen dem Knoten des Schalters und der Umgebung größer wird und die Durchflussrate unverändert bleibt, ein Vorwarnsignal auszusenden und zu bestimmen, ob eine Struktur oder ein wärmeleitendes Medium einer Kühlkomponente in dem Wärmeableitsystem anormal ist, und

wenn der Wärmewiderstand zwischen dem Knoten des Schalters und der Umgebung unverändert bleibt und die Durchflussrate größer wird, ein Vorwarnsignal auszusenden und festzustellen, ob eine Struktur oder ein wärmeleitendes Medium einer Kühlkomponente in dem Wärmeableitsystem anormal ist.

9. Vorrichtung nach Anspruch 8, wobei der mindestens eine Parameter eines oder mehrere der Folgenden umfasst: die Umgebungstemperatur, in der sich das Energiemodul befindet, eine Innentemperatur des Schalters, eine Schaltfrequenz des Schalters, einen Ausgangsstrom des Energiemoduls, eine Spannung der Gleichstromsammelschiene, eine Einlasstemperatur einer Kühlkomponente des Wärmeableitsystems und eine Auslasstemperatur der Kühlkomponente des Wärmeableitsystems.

10. Vorrichtung nach Anspruch 8, wobei das Bestimmungsmodul (706) ferner dazu konfiguriert ist, zu bestimmen, dass sich das Wärmeableitsystem in einem guten Zustand befindet, wenn der Wärmewiderstand zwischen dem Knoten des Schalters und der Umgebung kleiner als der erste voreingestellte Wert ist, und ein Vorwarnsignal zu senden, wenn der Wärmewiderstand zwischen dem Knoten des Schalters und der Umgebung größer als der erste voreingestellte Wert ist.

11. Vorrichtung nach Anspruch 8, wobei das Bestimmungsmodul (706) ferner dazu konfiguriert ist: den Wärmewiderstand zwischen einem Knoten des Schalters und der Umgebung mit einem zweiten voreingestellten Wert zu vergleichen und ein Fehlerabschaltsignal auszusenden, wenn der Wärmewiderstand den zweiten voreingestellten Wert überschreitet.

12. Vorrichtung nach Anspruch 8, wobei das Verarbeitungsmodul (704) ferner dazu konfiguriert ist:

die Verlustleistung des Schalters gemäß dem mindestens einen Parameter zu berechnen und die Kühlfluid-Durchflussrate des Wärmeableitsystems gemäß der folgenden Formel zu berechnen:

$$Q = \frac{P_{loss}}{\lambda * (T_{out-} T_{in}) * C}$$

wobei $P_{loss}$ die Verlustleistung des Schalters ist, $T_{in}$ eine Einlasstemperatur einer Kühlkomponente ist, $T_{out}$ eine Auslasstemperatur der Kühlkomponente ist, C eine spezifische Wärmekapazität der Kühlflüssigkeit ist, $\lambda$ ein Leitungskorrekturparameter ist, und die spezifische Wärmekapazität C der Kühlflüssigkeit und der Leitungskorrekturparameter $\lambda$ vorgegebene Parameter sind, die mittels externer Kommunikation eingestellt werden.

13. Vorrichtung nach Anspruch 8, wobei das Verarbeitungsmodul (704) ferner dazu konfiguriert ist:

die interne Sperrschichttemperatur des Schalters nach der folgenden Formel zu berechnen:

$$T_{j} = P_{loss} * R_{ja} + T_{a}$$

wobei $P_{loss}$ die Verlustleistung des Schalters ist, $R_{ja}$ ein Wärmewiderstand zwischen einem Knoten des Schalters und der Umgebung ist und $T_{a}$ die Umgebungstemperatur ist, und wobei das Bestimmungsmodul (706) ferner dazu konfiguriert ist: ein Übertemperatur-Vorwarnsignal auszusenden, wenn die interne Sperrschichttemperatur des Schalters einen dritten voreingestellten Wert überschreitet, und ein Übertemperatur-Fehlersignal auszusenden, wenn die interne Sperrschichttemperatur des Schalters einen vierten voreingestellten Wert überschreitet.

**Revendications**

1. Procédé d'évaluation d'un état de système de dissipation de chaleur pour un module de puissance, le module de puissance comprenant au moins un commutateur, une barre omnibus à courant continu, un système de dissipation de chaleur et un appareil d'évaluation d'état de système de dissipation de chaleur, le procédé comprenant :

l'acquisition (S802) d'au moins un paramètre du module de puissance par le biais d'un module d'acquisition (702) de l'appareil d'évaluation d'état de système de dissipation de chaleur ;
le calcul (S806), par un module de traitement (704) de l'appareil d'évaluation d'état de système de dissipation de chaleur, d'une résistance thermique entre un nœud du commutateur et un environnement sur la base de paramètres comprenant une température d'environnement où le module de puissance est situé, une température de thermistance interne du commutateur, une puissance de perte du commutateur, et une résistance thermique entre un nœud interne du commutateur et une thermistance ;
le calcul (S808), par le module de traitement (704) de l'appareil d'évaluation d'état de système de dissipation de chaleur, d'un débit de fluide de refroidissement sur la base de l'au moins un paramètre parmi les paramètres ;
**caractérisé en ce qu'**il comprend en outre :

la comparaison (S810), par un module de détermination (706) de l'appareil d'évaluation d'état de système de dissipation de chaleur, de la résistance thermique entre un nœud du commutateur et l'environnement avec une première valeur prédéfinie, et la détermination de l'état de système de dissipation de chaleur selon un résultat de comparaison ; et
la détermination (S812), par le module de détermination (706) de l'appareil d'évaluation d'état de système de dissipation de chaleur, d'une cause de défaillance sur la base de la résistance thermique entre le nœud du commutateur et l'environnement et une variation du débit de fluide de refroidissement,
dans lequel la détermination (S812) de la cause de défaillance sur la base de la résistance thermique entre le nœud du commutateur et l'environnement et une variation du débit comprend :

lorsque la résistance thermique entre le nœud du commutateur et l'environnement devient plus grande et le débit devient plus petit, l'envoi d'un signal d'avertissement, et la détermination, en outre, de si le signal d'avertissement est envoyé par une pluralité de modules de puissance, si tel est le cas, la détermination qu'une partie commune du système de dissipation de chaleur est anormale, et si tel n'est pas le cas, la détermination qu'un composant de refroidissement du module de puissance qui envoie un signal d'avertissement est anormalement bloqué ;
lorsque la résistance thermique entre le nœud du commutateur et l'environnement devient plus grande et le débit reste inchangé, l'envoi d'un signal d'avertissement, et la détermination de si une structure ou un milieu de conduction de chaleur d'un composant de refroidissement dans le système de dissipation de chaleur est anormal(e) ; et
lorsque la résistance thermique entre le nœud du commutateur et l'environnement reste inchangée et le débit devient plus grand, l'envoi d'un signal d'avertissement, et la détermination de si une structure ou un milieu de conduction de chaleur d'un composant de refroidissement dans le système de dissipation de chaleur est anormal(e).

2. Procédé selon la revendication 1, dans lequel l'au moins un paramètre comprend l'un ou plusieurs parmi : la température d'environnement où le module de puissance se trouve, une température interne du commutateur, une fréquence de commutation du commutateur, un courant de sortie du module de puissance, une tension de la barre omnibus à courant continu, une température d'entrée d'un composant de refroidissement du système de dissipation de chaleur, et une température de sortie du composant de refroidissement du système de dissipation de chaleur.

3. Procédé selon la revendication 1, dans lequel le calcul (S806) de la résistance thermique entre le nœud du commutateur et l'environnement comprend : le calcul (S804) de la puissance de perte du commutateur selon l'au moins un paramètre, et le calcul de la résistance thermique entre un nœud du commutateur et l'environnement selon la formule suivante,

$$R_{ja} = R_{jn} + \frac{T_{ntc} - T_a}{P_{loss}} \; ;$$

dans laquelle $P_{loss}$ est la puissance de perte du commutateur, $T_{ntc}$ est la température interne du commutateur, $T_a$ est la température d'environnement, $R_{jn}$ est la résistance thermique entre le nœud interne du commutateur et la thermistance, et la résistance thermique $R_{jn}$ entre le nœud interne du commutateur et la thermistance est un paramètre donné qui est ajusté par le biais d'une communication externe.

4. Procédé selon la revendication 1, dans lequel la comparaison (S810) de la résistance thermique entre le nœud du commutateur et l'environnement avec une première valeur prédéfinie et la détermination de l'état de système de dissipation de chaleur selon un résultat de comparaison comprend : la détermination que le système de dissipation de chaleur est en bon état lorsque la résistance thermique entre le nœud du commutateur et l'environnement est inférieure à la première valeur prédéfinie ; et l'envoi d'un signal d'avertissement lorsque la résistance thermique entre le nœud du commutateur et l'environnement est supérieure à la première valeur prédéfinie.

5. Procédé selon la revendication 1, comprenant en outre : la comparaison de la résistance thermique entre le nœud du commutateur et l'environnement avec une deuxième valeur prédéfinie, et l'envoi d'un signal de coupure sur défaillance lorsque la résistance thermique dépasse la deuxième valeur prédéfinie.

6. Procédé selon la revendication 1, dans lequel le calcul d'un débit de fluide de refroidissement comprend :

le calcul (S804) de la puissance de perte du commutateur selon l'au moins un paramètre et le calcul du débit de fluide de refroidissement du système de dissipation de chaleur selon la formule suivante,

$$Q = \frac{P_{loss}}{\lambda * (T_{out} - T_{in}) * C} \ ;$$

dans laquelle $P_{loss}$ est la puissance de perte du commutateur, $T_{in}$ est une température d'entrée d'un composant de refroidissement, $T_{out}$ est une température de sortie du composant de refroidissement, C est une capacité calorifique spécifique du fluide de refroidissement, À est un paramètre de correction de conduction, et la capacité calorifique spécifique C du fluide de refroidissement et le paramètre de correction de conduction $\lambda$ sont des paramètres donnés qui sont ajustés par le biais d'une communication externe.

7. Procédé selon la revendication 1, comprenant en outre : le calcul (S804) de la puissance de perte du commutateur selon l'au moins un paramètre, et le calcul d'une température de jonction interne du commutateur selon la formule suivante,

$$T_j = P_{loss} * R_{ja} + T_a \ ;$$

dans laquelle $P_{loss}$ est la puissance de perte du commutateur, $R_{ja}$ est une résistance thermique entre un nœud du commutateur et l'environnement, et $T_a$ est la température

d'environnement ; et lorsque la température de jonction interne du commutateur dépasse une troisième valeur prédéfinie, un signal d'avertissement de surchauffe est envoyé, et lorsque la température de jonction interne du commutateur dépasse une quatrième valeur prédéfinie, un signal de défaillance par surchauffe est envoyé.

8. Appareil d'évaluation d'un état de système de dissipation de chaleur pour un module de puissance, l'appareil d'évaluation d'un état de système de dissipation de chaleur étant situé dans le module de puissance, dans lequel le module de puissance comprend au moins un commutateur, une barre omnibus à courant continu et un système de dissipation de chaleur, et l'appareil comprend :

un module d'acquisition (702), configuré pour acquérir au moins un paramètre du module de puissance ; un module de traitement (704), configuré pour calculer une résistance thermique entre un nœud du commutateur et l'environnement sur la base de paramètres comprenant une température d'environnement où le module de puissance est situé, une température de thermistance interne du commutateur, une puissance de perte du commutateur, et une résistance thermique entre un nœud interne du commutateur et une thermistance, et calculer un débit de fluide de refroidissement sur la base de l'au moins un paramètre parmi les paramètres ; et **caractérisé en ce que** l'appareil comprend en outre :

un module de détermination (706), configuré pour comparer la résistance thermique entre un nœud du commutateur et l'environnement avec une première valeur prédéfinie, et déterminer l'état de système de dissipation de chaleur selon un résultat de comparaison, et déterminer une cause de défaillance sur la base de la résistance thermique entre le nœud du commutateur et l'environnement et une variation du débit de fluide de refroidissement, dans lequel le module de détermination (706) est outre configuré pour :

lorsque la résistance thermique entre le nœud du commutateur et l'environnement devient plus grande et le débit devient plus petit, envoyer un signal d'avertissement, et déterminer, en outre, si le signal d'avertissement est envoyé par une pluralité de modules de puissance, si tel est le cas, déterminer qu'une partie commune du système de dissipation de chaleur est anormale, et si tel n'est pas le cas, déterminer qu'un composant de refroidissement du module de puissance qui envoie un signal d'avertissement est anormalement bloqué ;

lorsque la résistance thermique entre le nœud du commutateur et l'environnement devient plus grande et le débit reste inchangé, envoyer un signal d'avertissement, et déterminer si une structure ou un milieu de conduction de chaleur d'un composant de refroidissement dans le système de dissipation de chaleur est anormal(e) ; et

lorsque la résistance thermique entre le nœud du commutateur et l'environnement reste inchangée et le débit devient plus grand, envoyer un signal d'avertissement, et déterminer si une structure ou un milieu de conduction de chaleur d'un composant de refroidissement dans le système de dissipation de chaleur est anormal(e).

9. Appareil selon la revendication 8, dans lequel l'au moins un paramètre comprend l'un ou plusieurs parmi : la température d'environnement où le module de puissance se trouve, une température interne du commutateur, une fréquence de commutation du commutateur, un courant de sortie du module de puissance, une tension de la barre omnibus à courant continu, une température d'entrée d'un composant de refroidissement du système de dissipation de chaleur, et une température de sortie du composant de refroidissement du système de dissipation de chaleur.

10. Appareil selon la revendication 8, dans lequel le module de détermination (706) est outre configuré pour :
déterminer que le système de dissipation de chaleur est en bon état lorsque la résistance thermique entre le nœud du commutateur et l'environnement est inférieure à la première valeur prédéfinie ; et envoyer un signal d'avertissement lorsque la résistance thermique entre le nœud du commutateur et l'environnement est supérieure à la première valeur prédéfinie.

11. Appareil selon la revendication 8, dans lequel le module de détermination (706) est outre configuré pour :
comparer la résistance thermique entre un nœud du commutateur et l'environnement avec une deuxième valeur prédéfinie, et envoyer un signal de coupure sur défaillance lorsque la résistance thermique dépasse la deuxième valeur prédéfinie.

12. Appareil selon la revendication 8, dans lequel le module de traitement (704) est outre configuré pour :

calculer la puissance de perte du commutateur selon l'au moins un paramètre et calculer le débit de fluide de refroidissement du système de dissipation de chaleur selon la formule suivante,

$$Q = \frac{P_{loss}}{\lambda * (T_{out} - T_{in}) * C} \ ;$$

dans laquelle $P_{loss}$ est la puissance de perte du commutateur, $T_{in}$ est une température d'entrée d'un composant de refroidissement, $T_{out}$ est une température de sortie du composant de refroidissement, C est une capacité calorifique spécifique du fluide de refroidissement, $\lambda$ est un paramètre de correction de conduction, et la capacité calorifique spécifique C du fluide de refroidissement et le paramètre de correction de conduction $\lambda$ sont des paramètres donnés qui sont ajustés par le biais d'une communication externe.

13. Appareil selon la revendication 8, dans lequel le module de traitement (704) est outre configuré pour :

calculer une température de jonction interne du commutateur selon la formule suivante,

$$T_j = P_{loss} * R_{ja} + T_a \ ;$$

dans laquelle $P_{loss}$ est la puissance de perte du commutateur, $R_{ja}$ est une résistance thermique entre un nœud du commutateur et l'environnement, et $T_a$ est la température d'environnement ; et
le module de détermination (706) est outre configuré pour : lorsque la température de jonction interne du commutateur dépasse une troisième valeur prédéfinie, envoyer un signal d'avertissement de surchauffe, et lorsque la température de jonction interne du commutateur dépasse une quatrième valeur prédéfinie, envoyer un signal de défaillance par surchauffe.

Fig. 1 (Prior art)

<u>200</u>

Fig. 2

Single-phase topology

Two-phase topology

Three-phase topology

Fig. 3 (Prior art)

Fig. 4

201

502

504

503

505

501

Fig. 5

Fig. 6

Acquisition module 702

Processing module 704

Determining module 706

Fig. 7

Acquiring the environment temperature $T_a$ at which the power module 200 is located, the internal thermistor temperature $T_{ntc}$ of the switch, the output current of the power module, the switching frequency of the switch, the voltage of the DC busbar, the inlet temperature $T_{in}$ of the cooling component of the heat dissipation system, and the outlet temperature $T_{out}$ of the cooling component of the heat dissipation system

S802

Calculating the loss power $P_{loss}$ of the switch according to the voltage of the DC busbar, the output current of the power module and the switching frequency of the switch

S804

Calculating a thermal resistance $R_{ja}$ between a node of the switch and the environment according to the environment temperature $T_a$ where the power module is located, an internal thermistor temperature $T_{ntc}$ of the switch, a loss power $P_{loss}$, and a thermal resistance $R_{jn}$ between an internal node of the switch and a thermistor

S806

Calculating a cooling fluid flow rate Q according to an inlet temperature $T_{in}$ of the cooling component of the heat dissipation system, an outlet temperature $T_{out}$ of the cooling component of the heat dissipation system, the loss power $P_{loss}$, the specific heat capacity C of the cooling fluid, and the conduction correction parameter $\lambda$

S808

Comparing the thermal resistance $R_{ja}$ between the node of the switch and the environment with a first preset value, and determining the condition of the heat dissipation system based on the comparison result

S810

Determining a fault cause based on the thermal resistance $R_{ja}$ between the node of the switch and the environment and a change of the cooling fluid flow rate Q

S812

Fig. 8

Fig. 9

Fig. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5712802 A